(19) Europäisches Patentamt
European Patent Office
Office européen des brevets

(11) **EP 0 665 997 B1**

(12) **EUROPEAN PATENT SPECIFICATION**

(45) Date of publication and mention
of the grant of the patent:
**21.04.1999 Bulletin 1999/16**

(21) Application number: **93922971.2**

(22) Date of filing: **25.10.1993**

(51) Int Cl.[6]: **H03H 7/38**

(86) International application number:
**PCT/FI93/00436**

(87) International publication number:
**WO 94/10750 (11.05.1994 Gazette 1994/11)**

(54) **LINE DRIVER CIRCUIT**

**LEITUNGSTREIBERSCHALTUNG**

**CIRCUIT DE COMMANDE DE LIGNES**

(84) Designated Contracting States:
**DE DK FR GB IT NL SE**

(30) Priority: **26.10.1992 FI 924852**

(43) Date of publication of application:
**09.08.1995 Bulletin 1995/32**

(73) Proprietor: **NOKIA TELECOMMUNICATIONS OY**
**02150 Espoo (FI)**

(72) Inventor: **KATZ, Marcos**
**FIN-90100 Oulu (FI)**

(74) Representative: **Tomlinson, Kerry John**
**Frank B. Dehn & Co.,**
**European Patent Attorneys,**
**179 Queen Victoria Street**
**London EC4V 4EL (GB)**

(56) References cited:
**JP-A- 2 063 212          US-A- 1 625 840**
**US-A- 4 326 287          US-A- 4 388 716**
**US-A- 4 805 214**

## Description

The invention relates to a method according to the preamble of the attached claim 1 of matching a line driver circuit for different transmission lines and to a line driver circuit according to the preamble of attached claim 4. The line driver circuit according to the invention is intended to provide a desired signal level for a digital connection established by a transmission line, which may vary between at least two transmission lines having mutually different characteristic impedances. A transmission line means in this connection any transmission medium having a certain impedance level, such as a twisted pair or a coaxial cable.

JP-A-2063212 discloses a line driver circuit having two switching elements arranged to make the pulse width in the on-state equal to that in the off-state.

It is often desirable to use the same line driver circuit in connection with transmission lines having different characteristic impedances (connected e.g. to a 75 ohm cable or a 120 ohm cable). Then the line driver circuit has to provide suitable signal levels for the very transmission line to which it is connected each time. Each transmission line having a specific characteristic impedance has specific requirements for the amplitudes of pulses to be transmitted.

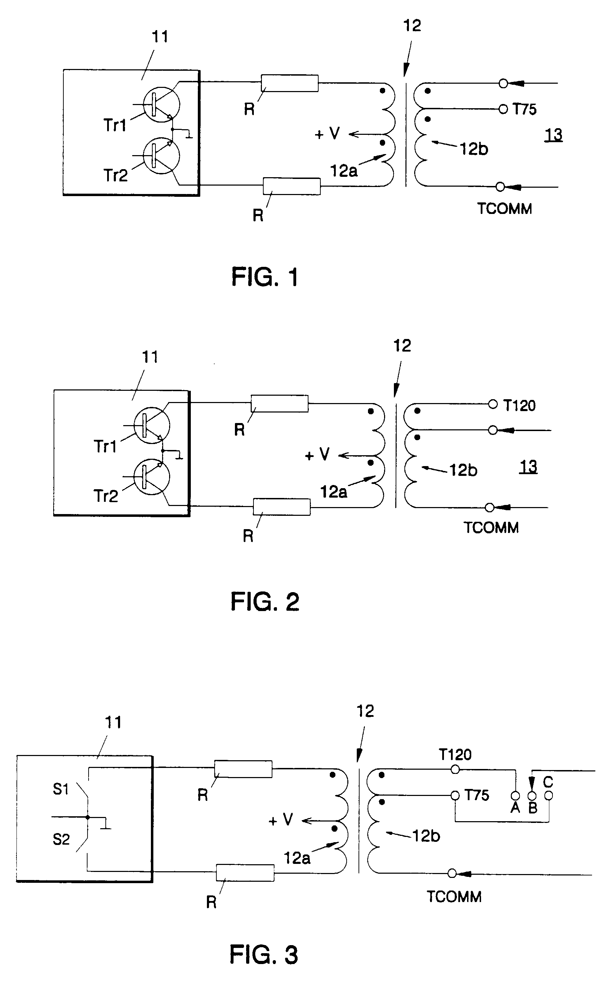

In known line driver circuits intended for use in connection with transmission lines having two different impedance levels, a secondary winding is provided with a tapping constituting an interface for a transmission line having another impedance level. Figures 1 and 2 illustrate such a line driver circuit according to the prior art, in which a driver stage 11 inputs an output signal via a transformer coupling 12 to a transmission line 13 connected to a secondary winding 12b of the transformer. Each output terminal of the driver stage is connected via a separate output resistor R to the respective terminal of a primary winding 12a. The driver stage typically comprises two transistors Tr1 and Tr2, one of which is conductive during a positive pulse and the other one during a negative pulse. An emitter of each transistor is connected to earth and a collector of each transistor constitutes the respective output terminal of the driver stage, which terminal is connected to the respective output resistor R. The line driver circuit provides an output signal for the transmission line, the signal levels of which signal are as desired and which signal may conform e.g. to an HDB3 line code known per se (a coding method recommended by the CCITT and used in PCM systems). The primary winding 12a of the transformer is provided with a tapping, which is connected to the operating voltage +V.

The driver stage may be e.g. a commercially available XR-T5675 manufactured by Exar, which circuit is intended to drive PCM lines up to a 10 Mbit/s rate.

The secondary winding of known line driver circuits is provided with a separate tapping, whereby two outputs are generated, depending on the impedance level of the cable to be used. If it is desirable to use the line driver circuit e.g. in connection with a 120 ohm symmetrical pair, the cable is connected to a corresponding terminal indicated by reference mark T120 and to a common terminal TCOMM (Figure 1). On the other hand, if it is desirable to use the line driver circuit e.g. in connection with a 75 ohm coaxial cable, the cable is connected to a corresponding terminal (tapping) indicated by reference mark T75 and to a common terminal TCOMM (Figure 2).

Drawbacks of the known solution described above are associated with the separate tapping of the secondary winding. Firstly, the separate tapping increases the complexity of the line driver circuit and thus the costs therefor. In this case, even the three terminals of the secondary winding have to be wired to a connector situated at the interface of the transmission line. This causes two other drawbacks. Firstly, an unused "floating" terminal tends to increase capacitive and inductive components in the output circuit, which may distort the shape of the signal to be transmitted, especially at high transmission speeds. Secondly, these wirings render the practical structure more complicated than before, particularly on circuit boards having several interfaces.

In known solutions, the line driver circuit may be provided, according to Figure 3, with terminals A to C, which are connected mechanically according to the impedance level used each time. When a 120 ohm cable is used, the terminals A and B are connected, and when a 75 ohm cable is used, the terminals B and C are connected. However, it should be preferable to try to avoid using mechanical switches for the selection of impedance level, because they make the structure more complicated and may cause crosstalk in some cases. Figure 3 shows the transistors Tr1 and Tr2 of the driver stage 11 as switches S1 and S2 (constituted by the transistors) describing their operation.

The object of the present invention is to get rid of the drawbacks described above and to provide such a line driver circuit in which the impedance level of a transmission line may be changed automatically without any changes being necessary in the line driver circuit. This is achieved by means of a method according to the invention, which is characterized in what is set forth in the characterizing portion of the attached claim 1. The line driver circuit according to the invention is, in turn, characterized in what is set forth in the characterizing portion of the attached claim 4.

The inventive idea is to determine output resistances and turns of windings in such a way that the signal levels required by the transmission lines are achieved without any changes in the circuit.

The circuit according to the invention has a simple structure, because transmission lines are supplied from the same terminals (thus only two terminals are needed) and no changes are necessary in the circuit when the impedance level of a connection is changed. The transformer coupling will also be simpler and cheaper, because no separate tapping of the secondary winding is needed any longer. Then the above problems caused by a floating connection are also avoided. However, since the structure is based on existing structures as well as possible in other aspects, the available technique may be utilized here as well as possible.

In the following, the invention will be explained in more detail with reference to the examples of Figures 4 to 6 in the attached drawings, in which

> Figures 1 and 2 show a known line driver circuit connectable to transmission lines having different characteristic impedances,
> Figure 3 shows another known line driver circuit connectable to transmission lines having different characteristic impedances,
> Figure 4 shows a line driver circuit according to the invention,
> Figure 5a shows an equivalent circuit of the line driver circuit according to Figure 4 during a pulse to be transmitted,
> Figure 5b shows the equivalent circuit of Figure 5a carried a step further, and
> Figure 6 shows finding optimum values in the solution according to the invention.

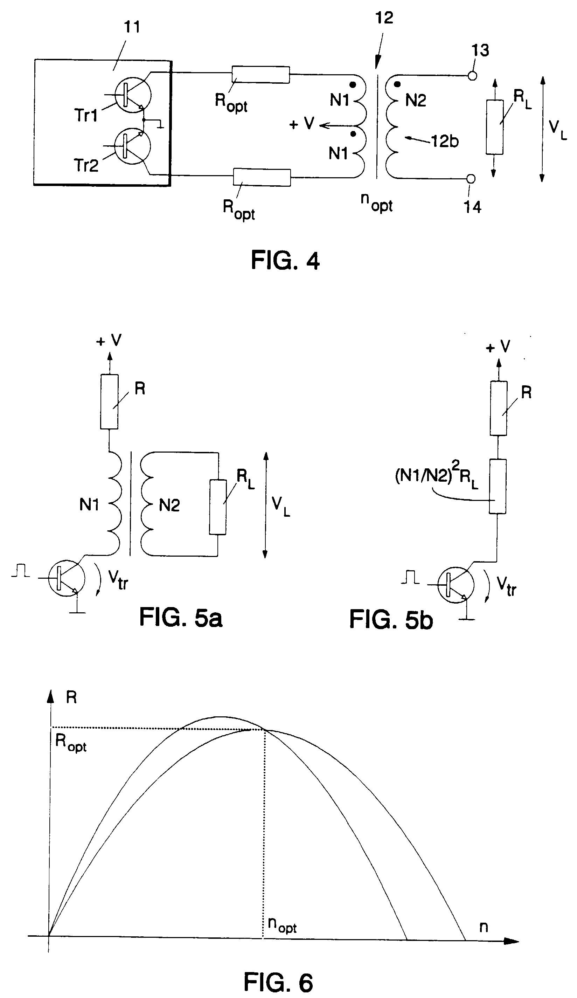

Figure 4 shows a line driver circuit according to the invention. The basic structure corresponds entirely to the basic structure shown in Figures 1 and 2, except that the structure according to the invention has fully eliminated the tapping of the secondary winding. The line driver circuit according to the invention can nevertheless be connected to transmission lines having mutually different impedance levels without any changes being necessary in the circuit. This is based on the idea of determining component values (output resistances and turns of windings) in such a way that suitable signal levels are provided for both impedance levels. Line impedance is indicated in Figure 4 by reference mark $R_L$ and the voltage (identical to the desired signal level) present across it by reference mark $V_L$. Consequently, two terminals 13 and 14 of a secondary winding of the line driver circuit according to the invention always constitute (irrespective of the impedance level of the transmission line) those connectors to which the transmission line is connected.

It is possible to generate for the circuit shown in Figure 4 oil equivalent circuit for the time of a transmitted pulse, which circuit is similar to that shown in Figure 5a arid in which circuit a collector of a switching transistor is connected to one terminal of a primary winding having N1 turns, the other terminal of which primary winding being coupled to an operating voltage +V via an output resistor R. (N1 is the number of turns of the primary winding of the transformer between the terminal of the winding and a center-tapping connected to the operating voltage, cf. Figure 4.) Terminals of the secondary winding (having N2 turns) are connected to a line impedance $R_L$. The saturation voltage of the switching transistor (collector-emitter voltage, when the switching transistor is conducting) is indicated by reference mark $V_{tr}$.

Further, the circuit of Figure 5a may be reduced to conform to the circuit of Figure 5b by replacing the transformer coupling and the line impedance by one equivalent impedance $R_{eq}$, the value of $R_{eq}$ being = $(N1/N2)^2 R_L$.

By means of the equivalent circuits described above, it is possible to prove that the value of the resistor R and the turns ratio of the windings n = N1/N2 have the following dependency:

$$(1) \qquad R = R_L \cdot n \left[ \frac{(V-V_{tr})}{V_L} - n \right]$$

When a first transmission line, for which $R_L=R_{L1}$ and $V_L=V_{L1}$, and a second transmission line, for which $R_L=R_{L2}$ and $V_L=V_{L2}$, are determined, common values $R_{opt}$ and $n_{opt}$ may be found for the resistor R and the turns ratio n, if the following equations (2) and (3) are satisfied simultaneously:

$$(2) \qquad n_{opt} = (V-V_{tr}) \frac{\left( \frac{R_{L1}}{V_{L1}} - \frac{R_{L2}}{V_{L2}} \right)}{(R_{L1} - R_{L2})} > 0$$

$$(3) \qquad R_{opt} = n^2_{opt} \frac{(V_{L2} - V_{L1})}{\left( \frac{V_{L1}}{R_{L1}} - \frac{V_{L2}}{R_{L2}} \right)} > 0$$

These equations may be reduced further to considerably simpler sets of conditions a and b:

a. $(V-V_{tr})>0$ and $\frac{V_{L1}}{V_{L2}} < \frac{R_{L1}}{R_{L2}}$ and $R_{L2}<R_{L1}$ and $V_{L2}<V_{L1}$

b. $(V-V_{tr})>0$ and $\frac{V_{L1}}{V_{L2}} > \frac{R_{L1}}{R_{L2}}$ and $R_{L2}>R_{L1}$ and $V_{L2}>V_{L1}$

Positive values are obtained for $R_{opt}$ and $n_{opt}$, if either set of conditions, a or b, is satisfied.

Figure 6 shows equation (1) graphically with the parameters $R_{L1}$, $V_{L1}$ and $R_{L2}$, $V_{L2}$, respectively, of two different transmission lines. If the common point of these two parabolas happens to be at positive values of R and n, this common point determines the optimal values $R_{opt}$ and $n_{opt}$, by which the desired signal level is provided for both transmission lines.

As a practical example may be mentioned a line driver circuit used either in connection with symmetrical pairs (a 120 ohm line) or a coaxial cable (a 75 ohm line) according to the CCITT recommendation G.703. The signal level required for the former and the latter

transmission line is $\pm 3$ V ($\pm 10\%$) and $\pm 2,37$ V ($\pm 10\%$), respectively. By using these signal levels as values for the quantities $V_{L1}$ and $V_{L2}$, respectively, and by selecting typical values $V = +5$ V and $V_{tr} = 0,6$ V for the quantities V and $V_{tr}$, the value of the output resistance will be (since the set of conditions a is satisfied) $R_{opt} = 63,7$ ohms and the turns ratio $n_{opt} = 0,81687$.

Though the invention has been described above referring to the examples according to the attached drawings, it is clear that the invention is not restricted to it, but it can be modified within the inventive idea presented above and in the attached claims. For instance, the invention is not restricted to be used in connection with the above-mentioned driver stage only, but it may be used with any driver stage the output stages of which have (transistor) switches in the manner described above. In principle, it is also possible to drive more than two transmission lines, but then the parameters of the other transmission lines have to be such that the graph of equation (1) passes through the point ($n_{opt}$, $R_{opt}$).

## Claims

1. A method of matching a line driver circuit for different transmission lines having mutually different characteristic impedances, which line driver circuit comprises a driver stage (11) and a transformer provided with primary and secondary windings (12a, 12b) in such a way that each output terminal of the driver stage (11) is connected to the corresponding terminal of the primary winding (12a) of the transformer via an output resistance (R) and the secondary winding (12b) of the transformer is intended to be connected to any of said different transmission lines (13), characterized in that the matching is carried out by selecting the values of output resistances and turns of the transformer ($R_{opt}$, $n_{opt}$) so that the same values provide the signal level required by any one of said transmission lines.

2. A method of matching according to claim 1 for two different transmission lines, characterized in that parameters of the line driver circuit are selected in such a way that the conditions
$(V-V_{tr})>0$ and $\frac{V_{L1}}{V_{L2}} < \frac{R_{L1}}{R_{L2}}$ and $R_{L2}<R_{L1}$ and $V_{L2}<V_{L1}$
are satisfied, where V is the operating voltage connected to a tapping of the primary winding (12a), $V_{tr}$ is the saturation voltage of a switching transistor at the driver stage output, $R_{L1}$ and $R_{L2}$ are the characteristic impedances of the transmission lines and $V_{L1}$ and $V_{L2}$ are the desired signal levels of the transmission lines.

3. A method of matching according to claim 1 for two different transmission lines, characterized in that parameters of the line driver circuit are selected in such a way that the conditions
$(V-V_{tr})>0$ and $\frac{V_{L1}}{V_{L2}} > \frac{R_{L1}}{R_{L2}}$ and $R_{L2}>R_{L1}$ and $V_{L2}>V_{L1}$
are satisfied, where V is the operating voltage connected to a tapping of the primary winding, $V_{tr}$ is the saturation voltage of a switching transistor at the driver stage output, $R_{L1}$ and $R_{L2}$ are the characteristic impedances of the transmission lines and $V_{L1}$ and $V_{L2}$ are the desired signal levels of the transmission lines.

4. A line driver circuit, comprising a driver stage (11) and a transformer provided with primary and secondary windings (12a, 12b) in such a way that output terminals of the driver stage (11) are connected to terminals of the primary winding (12a) of the transformer via an output resistor (R), which line driver circuit additionally comprises interface means for an alternative connection of different transmission lines thereto, the transmission lines having mutually different characteristic impedances, characterized in that the two terminals (13, 14) of the secondary winding constitute said interface means for said transmission lines, and the values of the output resistances and of turns of the transformer being such that the same values provide the signal level required by any one of said different transmission lines intended to be connected to said interface means.

5. A line driver circuit according to claim 4 for two different transmission lines, characterized in that values of the output resistances and turns of the transformer meet either one of the following conditions A) and B):

A) $(V-V_{tr})>0$ and $\frac{V_{L1}}{V_{L2}} < \frac{R_{L1}}{R_{L2}}$ and $R_{L2}<R_{L1}$ and $V_{L2}<V_{L1}$, or

B) $(V-V_{tr})>0$ and $\frac{V_{L1}}{V_{L2}} > \frac{R_{L1}}{R_{L2}}$ and $R_{L2}>R_{L1}$ and $V_{L2}>V_{L1}$,

where V is the operating voltage connected to a tapping of the primary winding (12a), $V_{tr}$ is the saturation voltage of a switching transistor at the driver stage output, $R_{L1}$ and $R_{L2}$ are the characteristic impedances of the transmission lines and $V_{L1}$ and $V_{L2}$ are the desired signal levels of the transmission lines.

## Patentansprüche

1. Verfahren zur Anpassung einer Leitungsansteuerungsschaltung für verschiedene Übertragungsleitungen mit wechselweise verschiedenen charakteristischen Impedanzen,

wobei die Leitungsansteuerungsschaltung eine Ansteuerungsstufe (11) und einen mit primären und sekundären Wicklungen (12a, 12b) versehenen Transformator aufweist,

so daß jeder Ausgangsanschluß der Ansteuerungsstufe (11) mit dem entsprechenden Anschluß der primären Wicklung (12a) des Transformators über einen Ausgangswiderstand (R) verbunden ist, und

die sekundäre Wicklung (12b) des Transformators dazu vorgesehen ist, an beliebige der verschiedenen Übertragungsleitungen (13) angeschlossen zu werden,

**dadurch gekennzeichnet, daß**

die Anpassung durch die Auswahl der Werte von Ausgangswiderständen und Windungszahl des Transformators ($R_{opt}$, $n_{opt}$) ausgeführt wird, so daß die gleichen Werte den für eine beliebige der Übertragungsleitungen erforderlichen Signalpegel bereitstellen.

2. Verfahren zur Anpassung nach Anspruch 1 für zwei verschiedenen Übertragungsleitungen,
   **dadurch gekennzeichnet, daß**
   die Parameter der Leitungsansteuerungsschaltung derart ausgewählt werden, daß die Bedingungen
   $(V-V_{tr}) > 0$ und $\frac{V_{L1}}{V_{L2}} < \frac{R_{L1}}{R_{L2}}$ und $R_{L2} < R_{L1}$ und $V_{L2} < V_{L1}$
   erfüllt sind, wobei V die an einen Abgriff der primären Wicklung (12a) angeschlossene Betriebsspannung ist, $V_{tr}$ die Sättigungsspannung eines Schalttransistors an dem Ansteuerungsstufenausgang ist, $R_{L1}$ und $R_{L2}$ die charakteristischen Impedanzen der Übertragungsleitungen sind und $V_{L1}$ und $V_{L2}$ die gewünschten Signalpegel der Übertragungsleitungen sind.

3. Verfahren zur Anpassung nach Anspruch 1 für zwei verschiedene Übertragungsleitungen,
   **dadurch gekennzeichnet, daß**
   die Parameter der Leitungsansteuerungsschaltung derart ausgewählt werden, daß die Bedingungen
   $(V-V_{tr}) > 0$ und $\frac{V_{L1}}{V_{L2}} > \frac{R_{L1}}{R_{L2}}$ und $R_{L2} > R_{L1}$ und $V_{L2} > V_{L1}$
   erfüllt sind, wobei V die an einen Abgriff der primären Wicklung angeschlossene Betriebsspannung ist, $V_{tr}$ die Sättigungsspannung eines Schalttransistors an dem Ansteuerungsstufenausgang ist, $R_{L1}$ und $R_{L2}$ die charakteristischen Impedanzen der Übertragungsleitungen sind und $V_{L1}$ und $V_{L2}$ die gewünschten Signalpegel der Übertragungsleitungen sind.

4. Leitungsansteuerungsschaltung mit

einer Ansteuerungsstufe (11) und
einem mit primären und sekundären Wicklungen (12a, 12b) versehenen Transformator,
so daß die Ausgangsanschlüsse der Ansteuerungsstufe (11) mit den Anschlüssen der primären Wicklung (12a) des Transformators über einen Ausgangswiderstand (R) verbunden sind, und
zusätzlich mit Schnittstelleneinrichtungen zur alternativen Verbindung von verschiedenen Übertragungsleitungen daran,
wobei die Übertragungsleitungen wechselweise verschiedene charakteristische Impedanzen aufweisen

**dadurch gekennzeichnet, daß**

die beiden Anschlüsse (13, 14) der sekundären Wicklung die Schnittstelleneinrichtungen für die Übertragungsleitungen bilden und
die Werte der Ausgangswiderstände und der Windungszahl des Transformators derart ausgebildet sind, daß die gleichen Werte den für eine beliebige der für den Anschluß an die Schnittstelleneinrichtungen vorgesehenen Übertragungsleitungen erforderlichen Signalpegel bereitstellen.

5. Leitungsansteuerungsschaltung nach Anspruch 4 für zwei verschiedene Übertragungsleitungen,
   **dadurch gekennzeichnet, daß**
   die Werte der Ausgangswiderstände und der Windungszahl des Transformators eine der nachstehenden Bedingungen A) und B) erfüllt:

   A) $(V-V_{tr}) > 0$ und $\frac{V_{L1}}{V_{L2}} < \frac{R_{L1}}{R_{L2}}$ und $R_{L2} < R_{L1}$ und $V_{L2} < V_{L1}$,

   B) $(V-V_{tr}) > 0$ und $\frac{V_{L1}}{V_{L2}} > \frac{R_{L1}}{R_{L2}}$ und $R_{L2} > R_{L1}$ und $V_{L2} > V_{L1}$,

   wobei V die an einen Abgriff der primären Wicklung (12a) angeschlossene Betriebsspannung ist, $V_{tr}$ die Sättigungsspannung eines Schalttransistors an dem Ansteuerungsstufenausgang ist, $R_{L1}$ und $R_{L2}$ die charakteristischen Impedanzen der Übertragungsleitungen sind und $V_{L1}$ und $V_{L2}$ die gewünschten Signalpegel der Übertragungsleitungen sind.

**Revendications**

1. Un procédé d'adaptation d'un circuit de commande de ligne pour différentes lignes de transmission ayant entre elles des impédances caractéristiques différentes, lequel circuit de commande de ligne comprend un étage de commande (11) et un transformateur équipé d'enroulements primaires et secondaires ( 12a, 12 b) de manière à ce que chaque borne de sortie de l'étage de commande (11) soit connectée à la sortie correspondante de l'enroulement primaire (12a) du transformateur via une résistance de sortie (R), et que l'enroulement secondaire (12b) du transformateur soit prévu pour être raccordé à l'une quelconque des dites différentes lignes de transmission (13), caractérisé en ce que l'adaptation est effectuée en choisissant les valeurs des résistances de sortie et les tours du transformateur ($R_{opt}$, $n_{opt}$) de telle sorte que les mêmes valeurs procurent le niveau de signal requis par l'une quelconque des lignes de transmission.

2. Un procédé d'adaptation selon la revendication 1, pour 2 lignes de transmission différentes, caractérisé en ce que les paramètres de la ligne de transmission sont choisis de telle sorte que les conditions
$(V - V_{tr}) > 0$ et $\frac{V_{L1}}{V_{L2}} < \frac{R_{L1}}{R_{L2}}$ et $R_{L2} < R_{L1}$ et $V_{L2} < V_{L1}$ soient satisfaites, où V est la tension de service raccordée à une prise de l'enroulement primaire (12a), $V_{tr}$ est la tension de saturation d'un transistor de commutation à une sortie de l'étage de commande, $R_{L1}$ et $R_{L2}$ sont les impédances caractéristiques des lignes de transmission, et $V_{L1}$ et $V_{L2}$ sont les niveaux voulus des signaux des lignes de transmission.

3. Un procédé d'adaptation selon la revendication 1, pour 2 lignes de transmission différentes, caractérisé en ce que les paramètres de circuit de commande de ligne de transmission sont choisis de telle sorte que les conditions
$(V - V_{tr}) > 0$ et $\frac{V_{L1}}{V_{L2}} > \frac{R_{L1}}{R_{L2}}$ et $R_{L2} > R_{L1}$ et $V_{L2} > V_{L1}$ soient satisfaites, où V est la tension de service raccordée à une prise de l'enroulement primaire $V_{tr}$ est la tension de saturation d'un transistor de commutation à la sortie de l'étage de commande, $R_{L1}$ et $R_{L2}$ sont les impédances caractéristiques des lignes de transmission, et $V_{L1}$ et $V_{L2}$ sont les niveaux voulus des signaux des lignes de transmission.

4. Un circuit de commande de ligne, comprenant un étage de commande (11) et un transformateur équipé d'enroulements primaires et secondaires (12a, 12b) de telle sorte que les bornes de sortie de l'étage de commande (11) soient raccordées aux bornes de l'enroulement primaire (12a) du transformateur via une résistance de sortie (R), ce circuit de commande de ligne comprenant de plus, des moyens d'interface pour le raccordement alternatif de lignes de transmission différentes, les lignes de transmission ayant entre elles des impédances caractéristiques différentes, caractérisé en ce que les bornes (13,14) de l'enroulement secondaire constituent lesdits moyens d'interface, et les valeurs des résistances de sortie et des nombres de tours du transformateur étant telles que les mêmes valeurs procurent le niveau de signal requis sur l'une quelconque desdites différentes lignes de transmission destinés à être raccordée aux dits dispositifs d'interface.

5. Un circuit de commande de ligne selon la revendication 4, pour deux différentes lignes d'émission, caractérisé en ce que les valeurs des résistances de sortie et du nombre de tours du transformateur sont en accord avec n'importe laquelle des conditions suivantes A) et B):

$(V - V_{tr}) > 0$ et $\frac{V_{L1}}{V_{L2}} < \frac{R_{L1}}{R_{L2}}$ et $R_{L2} < R_{L1}$ et $V_{L2} < V_{L1}$, ou

$(V - V_{tr}) > 0$ et $\frac{V_{L1}}{V_{L2}} > \frac{R_{L1}}{R_{L2}}$ et $R_{L2} > R_{L1}$ et $V_{L2} > V_{L1}$

où V est la tension de service raccordée à la prise de l'enroulement primaire (12a), $V_{tr}$ est la tension de saturation d'un transistor de commutation à la sortie de l'étage de commande, $R_{L1}$ et $R_{L2}$ sont les impédances caractéristiques des lignes de transmission, et $V_{L1}$ et $V_{L2}$ sont les niveaux voulus des signaux des lignes de transmission.

FIG. 1

FIG. 2

FIG. 3

FIG. 4

FIG. 5a

FIG. 5b

FIG. 6